# EUROPÄISCHE PATENTANMELDUNG

(11) **EP 4 273 910 A1**
(43) Veröffentlichungstag der Anmeldung: **08.11.2023**
(21) Anmeldenummer: 22171717.6
(22) Anmeldetag: 05.05.2022
(51) Int. Cl.: H01L 21/67, H01L 21/673, H01L 21/677

(54) **VORRICHTUNG ZUM VERPACKEN VON WAFERKASSETTEN**

(71) Anmelder: Siltronic AG, 81677 München (DE)
(72) Erfinder: Sollinger, Franz, 84570 Polling (DE); Esterl, Maximilian, 84552 Geratskirchen (DE); Gahn, Jochen, 84364 Bad Birnbach (DE); Köhler, Andreas, 84375 Kirchdorf (DE)

(57) **Zusammenfassung**

Vorrichtung zum Verpacken von Waferkassetten in eine Versandbox umfassend: Beladestation, die in der Lage ist, eine Versandbox für Halbleiterscheiben aufzunehmen **(101),** ein Element zum Beschreiben und Lesen eines an der Versandbox angebrachten RFID Tags **(102)** ein Element zur optischen Prüfung von Anbauteilen der Versandbox mittels einer Kamera **(103)** ein Element zum Bestücken der Versandbox mit einem Trockenmittelbeutel **(104),** Element zum Verschließen eines Beutels, der die Versandbox umgibt, mittels einer Schweißnaht **(105),** ein Element zum Überprüfen der Dichtigkeit einer Schweißnaht **(106)** ein Element zum Aufbringen von Etiketten auf eine Versandbox **(107),** Element zum automatischen Transport der Versandbox in Form eines Roboterarms **(108)** Element zum Lagern von Verpackungsmaterial **(109)** ein Element, das in der Lage ist, eine Versandbox für Halbleiterscheiben aufzunehmen und für den Abtransport zu lagern **(110).**

## Beschreibung

Gegenstand der vorliegenden Erfindung bezieht sich auf das Verpacken einer Waferkassette und insbesondere auf eine Verpackungsvorrichtung für eine Waferkassette, die in der Lage ist, eine Waferkassette automatisch zu verpacken.

Ein Wafer bezieht sich auf eine dünne Platte, die als Rohmaterial für eine integrierte Halbleiterschaltung (IC) verwendet wird, und wird hauptsächlich unter Verwendung eines Siliziummaterials hergestellt.

Ein Herstellungsprozess einer Halbleiterscheibe (Wafer) aus Silicium umfasst einen Einkristall-Züchtungsprozess zur Herstellung eines Einkristall-Siliziumblocks, einen Schneidprozess zum Erhalt eines dünnen scheibenförmigen Wafers durch Schneiden eines Einkristallblocks, einen Kantenschleifprozess zur Bearbeitung eines äußeren Umfangsabschnitts eines Wafers, um Risse und Verformungen des durch den Schneidprozess erhaltenen Wafers zu verhindern, ein Läppverfahren zur Beseitigung von Beschädigungen, die aufgrund der mechanischen Bearbeitung auf einem Wafer verbleiben, um die Ebenheit des Wafers zu verbessern, ein Polierverfahren zum Hochglanzpolieren eines Wafers und ein Reinigungsverfahren zum Entfernen von Schleifmitteln oder Fremdstoffen, die an einer Halbleiterscheibe haften.

Die durch diese verschiedenen Verfahren hergestellten Halbleiterscheiben werden in einer Kassette, z. B. einer Front-Open-Shipping-Box (FOSB), untergebracht, um Verunreinigungen zu vermeiden und sie vor äußeren Einflüssen zu schützen. Bevor sie verpackt und versandt werden, werden sie von außen mit einer Verpackungsfolie versiegelt.

Da die verpackten Halbleiterscheiben direkt in die Fertigungslinie der jeweiligen Hersteller von elektronischen Bauelementen geschickt werden und dort identifiziert werden müssen, spielt die Qualität der Verpackung eine äußerst große Rolle. Etiketten müssen beispielsweise exakt und reproduzierbar positioniert sein. Auch der Inhalt dieser Etiketten muss bei jeder Lieferung exakt mit dem Inhalt übereinstimmen. Zudem müssen sich die Halbleiterscheiben in der richtigen Reihenfolge in den jeweiligen Slots der Waferkassette befinden. Zudem müssen unterschiedliche Anforderung seitens der unterschiedlichen Hersteller von elektronischen Bauelementen Rechnung getragen werden. Beispielsweise müssen je nach Kunde die Etiketten unterschiedlich positioniert werden oder der Inhalt der Etiketten (in Barcode oder Schriftzeichen, oder beides) variiert je nach Kunde.

Die US 2020 219 741 A1 beschreibt eine Vorrichtung zum Verpacken von Waferkassetten, wobei die Vorrichtung umfasst:
ein Ladeteil, in das eine Waferkassette geladen wird; ein Zubehörinspektionsteil, das so konfiguriert ist, dass es eine an der Waferkassette angebrachte Rezeptur prüft und Zubehörteile der Waferkassette inspiziert; ein erstes Etikettenbefestigungsteil, das so konfiguriert ist, dass es ein erstes Etikett an der Waferkassette befestigt, an der die Zubehörinspektion abgeschlossen ist; ein Primärfolienpackteil, das so konfiguriert ist, dass es eine Primärfolie gemäß der Rezeptur aufnimmt und die Waferkassette unter Verwendung der Primärfolie verpackt; ein Sekundärfilm-Verpackungsteil, das so konfiguriert ist, dass es einen Sekundärfilm gemäß der Rezeptur aufnimmt und die Waferkassette unter Verwendung des Sekundärfilms sekundär verpackt; ein zweites Etikett-Befestigungsteil, das so konfiguriert ist, dass es ein zweites Etikett an dem Sekundärfilm befestigt, mit dem die Waferkassette verpackt worden ist; und ein Entladeteil, das so konfiguriert ist, dass es die Waferkassette, die vollständig verpackt worden ist, ausgibt.

Die JP 2015 058 958 A2 beschreibt ein Verpackungssystem, das eine Vielzahl von Klemmen zum Öffnen und Schließen der Beutelöffnung eines Seitenfaltenbeutels in einem horizontalen Zustand hat, in dem die Beutelöffnung an einem Ende ausgebildet ist, und einen Schlittenarm zum Einführen eines Behälters oder eines Verpackungsobjekts in den Seitenfaltenbeutel.

Keine der genannten Schriften kann vollumfänglich eine Vorrichtung zur Verfügung stellen, die in der Lage ist, die bereits genannten Probleme zu lösen.

Die Aufgabe der vorliegenden Erfindung besteht darin, eine Vorrichtung bereitzustellen, die die oben genannten Probleme minimiert und zudem in der Lage ist, den Durchsatz der Verpackungsanlage zu erhöhen.

### Kurzbeschreibung der Figuren

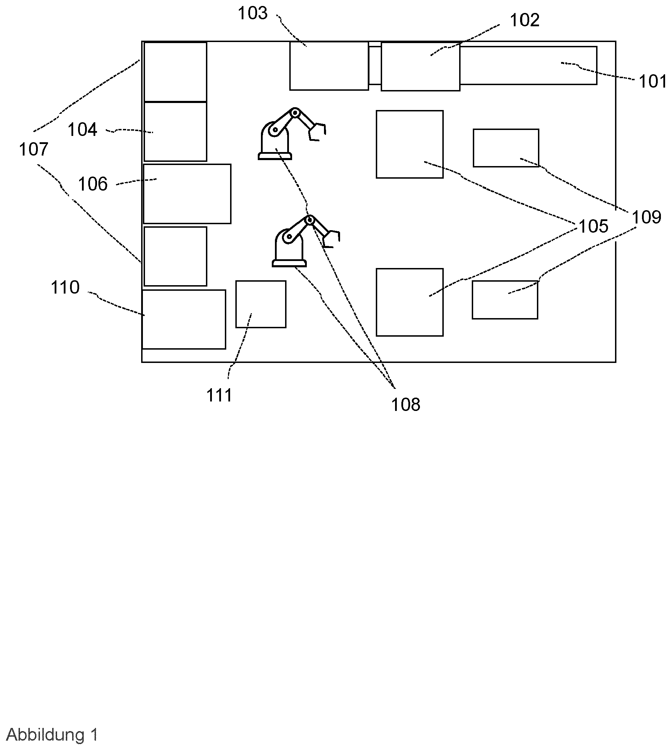

**Abbildung 1** zeigt eine exemplarische Ausprägung einer erfindungsgemäßen Vorrichtung zum Verpacken von Waferkassetten. Die Vorrichtung enthält dabei folgende Elemente:
- **101**: Beladestation, die in der Lage ist, eine Versandbox für Halbleiterscheiben aufzunehmen.
- **102**: Element zum Beschreiben und Lesen eines an der Versandbox angebrachten RFID Tags
- **103**: Element zur optischen Prüfung von Anbauteilen der Versandbox mittels einer Kamera
- **104**: Element zum Bestücken der Versandbox mit einem Trockenmittelbeutel
- **105**: Element zum Verschließen eines Beutels, der die Versandbox umgibt, mittels einer Schweißnaht,
- **106**: Element zum Überprüfen der Dichtigkeit einer Schweißnaht
- **107**: Element zum Aufbringen von Etiketten auf eine Versandbox
- **108**: Element zum automatischen Transport der Versandbox in Form eines Roboterarms
- **109**: Element zum Lagern von Verpackungsmaterial
- **110**: Element, das in der Lage ist, eine Versandbox für Halbleiterscheiben aufzunehmen und für den Abtransport zu lagern.

### Detaillierte Beschreibung erfindungsgemäßer Ausführungsbeispiele

Die erfindungsgemäße Vorrichtung zum Verpacken von Waferkassetten umfasst mehrere Elemente, die im Folgenden genauer beschrieben werden.

Bei den verwendeten Versandboxen handelt es sich um Behälter aus Kunststoff, beispielsweise aus Polycarbonat (PC), die Komponenten aus Polybutylenterephthalat (PBT), Polyolefin-Elastomere (POE) oder Polyethylethylen (PEE) beinhalten können. Diese Versandboxen werden üblicherweise als "front opening shippingbox" (FOSB) bezeichnet.

Die erfindungsgemäße Vorrichtung umfasst eine automatische Beladestation (101), die in der Lage ist, eine Versandbox für Halbleiterscheiben aufzunehmen.

Die FOSB wird an der Beladestation **(101)** aufgestellt.

Die erfindungsgemäße Vorrichtung umfasst ferner ein Element zum automatischen Beschreiben und Lesen eines an der Versandbox angebrachten RFID Tags (102). Alternativ kann auch genau ein RFID Tag verwendet werden. Ein RFID Tag (englisch radio-frequency identification "Identifizierung mit Hilfe elektromagnetischer Wellen") bezeichnet eine Technologie für Sender-Empfänger-Systeme zum automatischen und berührungslosen Identifizieren und Lokalisieren von Objekten mit Radiowellen.

Die erfindungsgemäße Vorrichtung umfasst ebenfalls ein Element zum automatischen optischen Prüfen von Anbauteilen der Versandbox mittels einer Kamera (103). Für die Versandbox müssen etwaige Beschädigungen ausgeschlossen werden können, daher ist es wichtig diesbezüglich Prüfungen vorzunehmen. Alle Prüfergebnisse inkl. der Kamerabilder werden gespeichert.

Die erfindungsgemäße Vorrichtung enthält bevorzugt ein Element zur automatischen Überprüfung der korrekten Befüllung der Waferkassette. Die Aufgabe dieses Elementes ist es zum Beispiel, Halbleiter zu identifizieren, die falsch einsortiert wurden. Die Waferkassette weist eine Vielzahl von Aufnahmeschlitzen auf, die zum Halten von Halbleiterscheiben (engl. Wafer) voneinander beabstandet sind, die jeweils durch ein unteres bzw. oberes Polster an einer weiteren Bewegung gehindert werden. Ein häufiger Fehler kann ein sogenannter Crossslot-Fehler sein, bei dem , die Halbleiterscheibe schräg in der Waferbox einsortiert wurde.

Die erfindungsgemäße Vorrichtung enthält ferner bevorzugt einen Drucker zum Drucken von Etiketten, die verwendet werden, um auf die Box aufzukleben.

Die erfindungsgemäße Vorrichtung enthält auch eine Vorrichtung zum automatischen Aufbringen der Etiketten auf die Versandbox **(107).**

Ferner enthält die erfindungsgemäße Vorrichtung bevorzugt ein Element zur automatischen Kontrolle der angebrachten Etiketten auf der Versandbox. Hier wird beispielsweise geprüft, ob die Etiketten an der richtigen Position sitzen und/oder die aufgedruckten Inhalte lesbar sind und deren Inhalte mit dem gewünschten Inhalt übereinstimmen.

Bevorzugt wird nach dem die Label aufgeklebt sind, über ein Kamerasystem die aufgeklebte Position millimetergenau überprüft. Ebenfalls werden die gedruckten Inhalte der Labels überprüft. Es müssen alle Codes und Schriftzeichen lesbar und fehlerfrei gedruckt sein. Nicht bedruckte Bereiche der Label dürfen keine Druckfehler haben. Das Label wird mittels Bildabgleich mit einem via Druckdatei generierten Bild verglichen und auf einem Reproduktionsfaktor geprüft. Alle Testergebnisse werden gespeichert.

Ebenso enthält die erfindungsgemäße Vorrichtung eine Vorrichtung zum automatischen Verschließen eines inneren Beutels, der die Versandbox umgibt, mittels einer ersten Schweißnaht **(105).**

Und die erfindungsgemäße Vorrichtung enthält ein Element zum automatischen Überprüfen der Dichtigkeit der ersten Schweißnaht **(106).** Dabei wird zum Beispiel Unterdruck angewandt, um die Dichtheit der Schweißnaht zu überprüfen. Die verpackte FOSB wird in einer Vakuumkammer mittels Füllgasprüfung auf Dichtigkeitsgrad des Beutels geprüft. Das Prüfergebnis wird in der EDV gespeichert.

Die erfindungsgemäße Vorrichtung enthält zusätzlich ein Element zum automatischen Bestücken der Versandbox mit einem Trockenmittelbeutel **(104).** Trockenmittelbeutel sind in der Regel mit Silicagel gefüllt und eignen sich dafür Feuchtigkeit aus der Luft aufzunehmen und so Kondensatbildung zu vermeiden. Es ist unbedingt erforderlich, dass die Trockenmittelbeutel immer an derselben Position in der Versandbox positioniert werden. Ein Trockenmittelbeutel wird automatisch angeklebt.

Die erfindungsgemäße Vorrichtung enthält bevorzugt auch ein Element zum Verschließen eines äußeren Beutels, der die Versandbox umgibt, mittels einer zweiten Schweißnaht. Das Material, das für den äußeren Beutel verwendet wird, unterscheidet sich meist von dem Material, das für den inneren Beutel verwendet wird. Nach dem Zufalten des Beutels wird die Luft aus dem Beutel gezogen und eine einstellbare, definierte Menge an Gas zugeführt. Danach wird der Beutel verschweißt. Der Überstand des Beutels wird gefaltet und angeklebt.

Die erfindungsgemäße Vorrichtung enthält bevorzugt ein Element zum automatischen Überprüfen der Dichtigkeit der zweiten Schweißnaht. Dabei wird bevorzugt Unterduck verwendet. Die verpackte FOSB wird in einer Vakuumkammer mittels Füllgasprüfung auf Dichtigkeitsgrad des Beutels geprüft. Das Prüfergebnis wird gespeichert.

Die erfindungsgemäße Vorrichtung enthält zusätzlich ein Element zum automatischen Transport der Versandbox **(108).** Geeignet sind hierbei Transportvorrichtungen in Form eines Roboterarmes.

Außerdem enthält die erfindungsgemäße Vorrichtung ein Element, das in der Lage ist, eine Versandbox für Halbleiterscheiben aufzunehmen und für den Abtransport zu lagern.

## Patentansprüche

1. Vorrichtung zum Verpacken von Waferkassetten in eine Versandbox umfassend:
Beladestation, die in der Lage ist, eine Versandbox für Halbleiterscheiben aufzunehmen **(101),**
ein Element zum Beschreiben und Lesen eines an der Versandbox angebrachten RFID Tags **(102)**
ein Element zur optischen Prüfung von Anbauteilen der Versandbox mittels einer Kamera **(103)**
ein Element zum Bestücken der Versandbox mit einem Trockenmittelbeutel **(104),**
Element zum Verschließen eines Beutels, der die Versandbox umgibt, mittels einer Schweißnaht **(105),**
ein Element zum Überprüfen der Dichtigkeit einer Schweißnaht **(106)**
ein Element zum Aufbringen von Etiketten auf eine Versandbox **(107),**
Element zum automatischen Transport der Versandbox in Form eines Roboterarms **(108)**
Element zum Lagern von Verpackungsmaterial **(109)**
ein Element, das in der Lage ist, eine Versandbox für Halbleiterscheiben aufzunehmen und für den Abtransport zu lagern **(110).**

## Geänderte Patentansprüche

### Geänderte Patentansprüche gemäss Regel 137(2) EPÜ.

1. Vorrichtung zum Verpacken von Waferkassetten in eine Versandbox umfassend:
eine Beladestation, die in der Lage ist, eine Versandbox für Halbleiterscheiben aufzunehmen **(101),**
ein Element zum Beschreiben und Lesen eines an der Versandbox angebrachten RFID Tags **(102),**
ein Element zur optischen Prüfung von Anbauteilen der Versandbox mittels einer Kamera **(103),**
ein Element zum Bestücken der Versandbox mit einem Trockenmittelbeutel **(104),**
ein Element zum Verschließen eines Beutels, der die Versandbox umgibt, mittels einer Schweißnaht **(105),**
ein Element zum Überprüfen der Dichtigkeit einer Schweißnaht **(106),**
ein Element zum Aufbringen von Etiketten auf eine Versandbox **(107),**
ein Element zum automatischen Transport der Versandbox in Form eines Roboterarms **(108),**
ein Element zum Lagern von Verpackungsmaterial **(109)** und
ein Element, das in der Lage ist, eine Versandbox für Halbleiterscheiben aufzunehmen und für den Abtransport zu lagern **(110).**
